# EUROPEAN PATENT SPECIFICATION

(11) **EP 4 366 127 B1**
(45) Date of publication and mention of the grant of the patent: **15.04.2026**
(21) Application number: 22873078.4
(22) Date of filing: 08.07.2022
(51) Int. Cl.: H02J 50/00, H02J 50/10, H01F 38/14, H01F 27/29, H01F 27/30, H01F 27/28, H02J 50/12, H02J 50/80, H04M 1/02, H01F 27/02

(54) **COVER MEMBER AND ELECTRONIC DEVICE COMPRISING COVER MEMBER**
ABDECKELEMENT UND ELEKTRONISCHE VORRICHTUNG MIT ABDECKELEMENT
ÉLÉMENT DE COUVERCLE ET DISPOSITIF ÉLECTRONIQUE COMPRENANT UN ÉLÉMENT DE COUVERCLE

(30) Priority: 27.09.2021 KR 20210127093
(43) Date of publication of application: 08.05.2024
(73) Proprietor: Samsung Electronics Co., Ltd., Suwon-si, Gyeonggi-do 16677 (KR)
(72) Inventor: NA, Sangsik, Suwon-si, Gyeonggi-do 16677 (KR); HWANG, Hangyu, Suwon-si, Gyeonggi-do 16677 (KR); KIM, Changsu, Suwon-si, Gyeonggi-do 16677 (KR); GONG, Yeonghwan, Suwon-si, Gyeonggi-do 16677 (KR); CHO, Sungho, Suwon-si, Gyeonggi-do 16677 (KR)
(74) Representative: HGF
(86) International application number: PCT/KR2022/009946
(87) International publication number: WO 2023/048372

(56) References cited:
- WO-A1-2012/027531
- KR-A- 20150 047 347
- KR-A- 20160 089 234
- KR-A- 20210 047 167
- KR-B1- 102 235 490
- KR-U- 20150 002 449
- US-A1- 2013 176 179
- US-A1- 2013 267 170
- US-A1- 2020 235 593

## Description

### [Technical Field]

The disclosure relates to a cover member and/or an electronic device including the cover member.

### [Background Art]

Advancing information communication and semiconductor technologies accelerate the spread and use of various electronic devices. In particular, recent electronic devices are being developed to carry out communication while carried on.

The term "electronic device" may mean a device performing a particular function according to its equipped program, such as a home appliance, an electronic scheduler, a portable multimedia player, a mobile communication terminal (e.g., mobile phone), a tablet PC, a video/sound device, a desktop PC or laptop computer, a navigation for automobile, etc. For example, electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including one or more of an entertainment function, such as playing video games, a multimedia function, such as replaying music/videos, a communication and security function for mobile banking, and a scheduling or e-wallet function. Such electronic devices become compact enough for users to carry in a convenient way.

Further, in an information-based society, in order for information communication devices to connect and operate with each other irrespective of time or place, the importance of supplying power to electronic devices is increasingly being emphasized. Wireless power transfer technology for providing a simpler method for supplying power to an electronic device and/or charging the battery included in the electronic device is recently attracting attention. For example, a wireless power reception device, such as a mobile device that receives energy wirelessly, may be driven by the received wireless power or may charge a battery with the received wireless power and be driven by the charged power.

Wireless power transmission or wireless energy transfer is a technology for wirelessly transmitting electrical energy from a transmitter to a receiver by magnetic field induction for example. Wireless energy transfer schemes may largely be divided, for example, into a magnetic induction scheme, an electromagnetic resonance scheme, and a short-wavelength radio frequency-based power transmission scheme.

### [Disclosure]

### [Technical Problem]

In general, a structure for wireless charging may be disposed toward the rear surface (e.g., the direction opposite to the direction in which the display is disposed) of the electronic device. The wireless charging structure may be manufactured by simply attaching a separate sheet including a wireless charging coil to the rear cover. Alternatively, the wireless charging structure may be manufactured by processing or etching a portion of the rear cover to secure a space for disposing the wireless charging coil and then fixing the wireless charging coil by a separate molding process.

When the separate sheet including the wireless charging coil is attached to the cover and disposed, the thickness of the structure related to the wireless charging coil is added in addition to that of the rear cover, thereby limiting the use of space inside the electronic device. When a wireless charging coil is embedded by processing a portion of the rear cover, and a separate computer numerical control (CNC) processing or etching process is required to secure a space for the wireless charging coil, this may result in increasing the processing costs. Further, to protect the wireless charging coil and to fix it to the rear cover, a process for a separate injection-molded article different from the material of the rear cover may be required. Accordingly, the eccentricity of the wireless charging coil may be deviated by the pressure and the flow of resin for the injection process, or the wireless charging coil may be escaped off due to failure to secure bonding force between the injection-molded article and the rear cover.

The electronic device according to the disclosure may provide a wireless charging structure capable of preventing or reducing eccentricity and deformation of the wireless charging coil inside the rear cover and securing coupling force.

The disclosure is not limited to the embodiments herein, but various modifications or changes may rather be made thereto without departing from the spirit and scope of the disclosure.

The documents US2013176179A1, KR102235490B1 and US2013267170A1 disclose electronic devices comprising a structure for wireless charging.

### [Technical Solution]

According to the invention, an electronic device comprises a housing forming at least a portion of an exterior of the electronic device, a wireless charging structure positioned in a recess of the housing, and a circuit board disposed in the housing and electrically connected with the wireless charging structure. The wireless charging structure includes a wireless charging coil and an insert portion formed to surround at least a portion of the wireless charging coil. The recess of the housing includes at least one protrusion for coupling with the insert portion, and the insert portion includes at least one receiving portion disposed along an edge of the wireless charging structure to couple with the at least one protrusion.

According to various example embodiments of the disclosure, an electronic device may comprise a housing forming at least a portion of an exterior of the electronic device, a wireless charging structure at least partially positioned in a recess formed in an inner surface of the housing, and a circuit board disposed in the housing and electrically connected with the wireless charging structure. The wireless charging structure may include a wireless charging coil and an insert portion formed to surround at least a portion of the wireless charging coil. The insert portion may include a guide slot formed to align a position of the wireless charging coil.

The invention is set out in the appended set of claims.

### [Advantageous Effects]

According to various example embodiments of the disclosure, in the electronic device, the wireless charging coil (and/or terminals) are molded with a thermosetting material to form a first insert component (e.g., wireless charging structure). With the first insert component inserted in a mold for forming a rear cover, a thermoplastic material is injected. Thus, it is possible to provide a rear cover on which the wireless charging coil (and/or terminals) are disposed, without increasing the thickness and processing costs.

According to various example embodiments of the disclosure, in the electronic device, the guide slot is formed in the insert portion. Thus, it is possible to implement a wireless charging coil which overall remains leveled while preventing or reducing eccentricity.

Effects of the disclosure are not limited to the foregoing, and other unmentioned effects would be apparent to one of ordinary skill in the art from the following description.

### [Description of the Drawings]

The above and other aspects, features and advantages of certain embodiments of the present disclosure will be more apparent from the following detailed description, taken in conjunction with the accompanying drawings, in which:
FIG. 1 is a view illustrating an electronic device in a network environment according to various example embodiments;
FIG. 2 is a front perspective view illustrating an electronic device according to various example embodiments of the disclosure;
FIG. 3 is a rear perspective view illustrating an electronic device according to various example embodiments of the disclosure;
FIG. 4 is an exploded perspective view illustrating an electronic device according to various example embodiments of the disclosure;
FIG. 5 is a block diagram illustrating a wireless charging system according to various example embodiments of the disclosure;
FIG. 6 is a perspective view illustrating a stack structure of an electronic device according to one of various example embodiments of the disclosure;
FIG. 7 is a view illustrating a wireless charging structure disposed inside a rear plate of an electronic device according to various example embodiments of the disclosure;
FIG. 8 is a cross-sectional view illustrating a wireless charging structure and a rear plate taken along A-A' of the electronic device of FIG. 7, according to various example embodiments of the disclosure;
FIG. 9 is a view illustrating a wireless charging structure disposed inside a rear plate of an electronic device according to another example embodiment of the disclosure;
FIG. 10 is a view illustrating a wireless charging structure disposed inside a rear plate of an electronic device according to another example embodiment of the disclosure;
FIG. 11 is a flowchart illustrating a method for manufacturing a wireless charging structure and disposing the wireless charging structure on a rear plate of an electronic device according to various example embodiments of the disclosure;
FIG. 12 is a perspective view illustrating a mold for inserting a wireless charging structure and a wireless charging coil according to various example embodiments of the disclosure; and
FIG. 13 is an enlarged view of area A of FIG. 12 according to various example embodiments of the disclosure.

### [Mode for Invention]

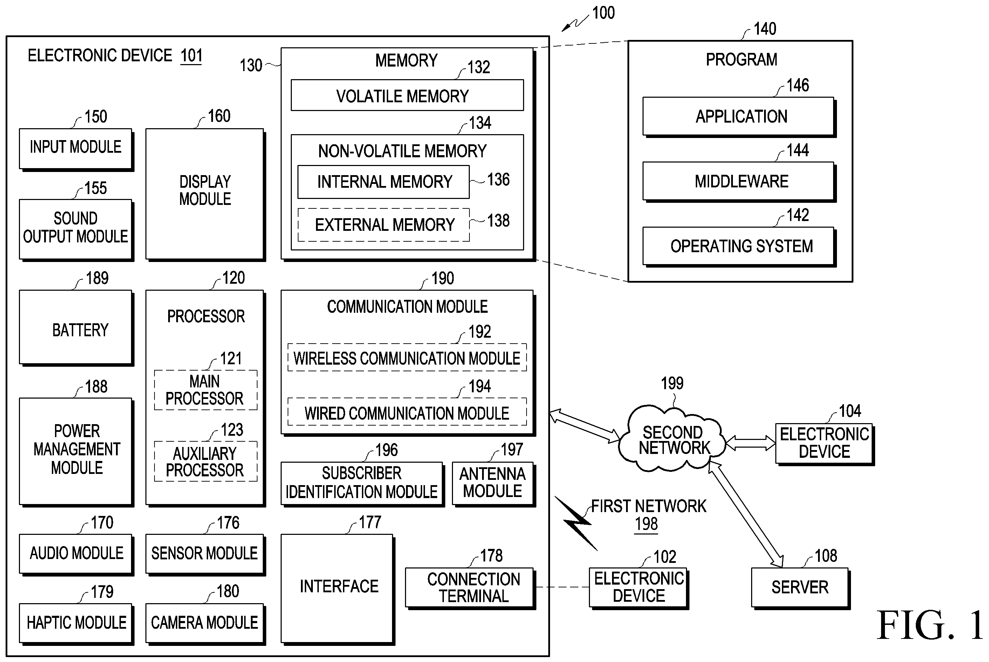

FIG. 1 is a block diagram illustrating an electronic device in a network environment according to various embodiments of the disclosure;
Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via a first network 198 (e.g., a short-range communication network, such as BluetoothTM, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module may include an antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smart phone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play StoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

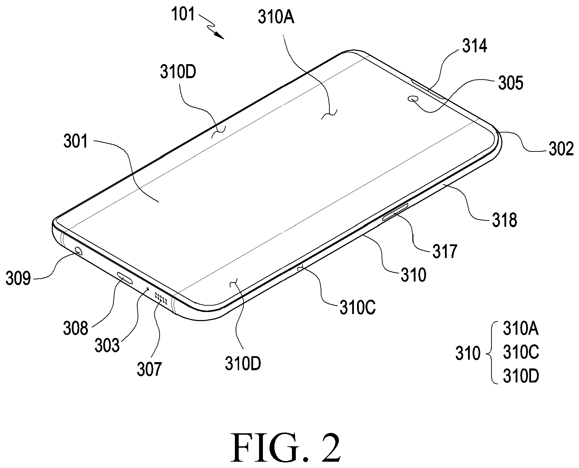

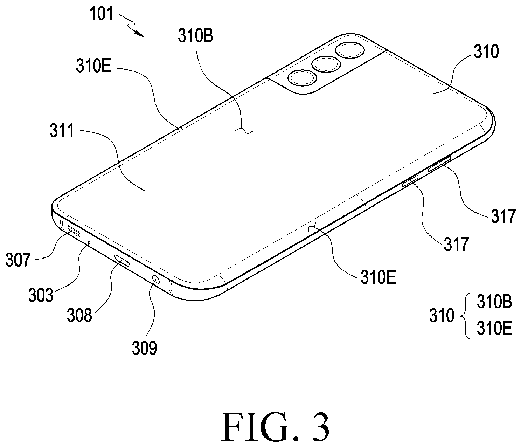

FIG. 2 is a front perspective view illustrating an electronic device according to various example embodiments of the disclosure; FIG. 3 is a rear perspective view illustrating an electronic device according to various example embodiments of the disclosure;

Referring to FIGS. 2 and 3, according to an embodiment, an electronic device 101 may include a housing 310 with a front surface 310A, a rear surface 310B, and a side surface 310C surrounding a space between the front surface 310A and the rear surface 310B. According to another embodiment (not shown), the housing 310 may denote a structure forming at least part of the front surface 310A, at least part of the rear surface 310B, and at least part of the side surface 310C of FIG. 2. According to an embodiment, at least part of the front surface 310A may have a substantially transparent front plate 302 (e.g., a glass plate or polymer plate including various coating layers). The rear surface 310B may be formed by a rear plate 311. The rear plate 311 may be formed of, e.g., glass, ceramic, polymer, metal (e.g., aluminum, stainless steel (STS), or magnesium), or a combination of at least two thereof. The side surface 310C may be formed by a side bezel structure (or a "side member") 318 that couples to the front plate 302 and the rear plate 311 and includes a metal and/or polymer. According to an embodiment, the rear plate 311 and the side bezel plate 318 may be integrally formed together and include the same material (e.g., glass, metal, such as aluminum, or ceramic).

In the embodiment illustrated, the front plate 302 may include two first edge areas 310D, which seamlessly and bendingly extend from the first surface 310A to the rear plate 311, on both the long edges of the front plate 302. In the embodiment (refer to FIG. 3) illustrated, the rear plate 311 may include two second edge areas 310E, which seamlessly and bendingly extend from the rear surface 310B to the front plate, on both the long edges. According to an embodiment, the front plate 302 (or the rear plate 311) may include only one of the first edge areas 310 (or the second edge areas 310E). Alternatively, the first edge areas 310D or the second edge areas 301E may partially be excluded. According to an embodiment, at side view of the electronic device 101, the side bezel structure 318 may have a first thickness (or width) for sides that do not have the first edge areas 310D or the second edge areas 310E and a second thickness, which is smaller than the first thickness, for sides that have the first edge areas 310D or the second edge areas 310E. The front plate and the rear plate, for example, may be considered part of the housing.

According to an embodiment, the electronic device 101 may include at least one of a display 301, audio modules 303, 307, and 314 (e.g., the audio module 170 of FIG. 1), a sensor module (e.g., the sensor module 176 of FIG. 1), camera modules 305, 312, and 313 (e.g., the camera module 180 of FIG. 1), a key input device 317 (e.g., the input module 150 of FIG. 1), and connector holes 308 and 309 (e.g., the connection terminal 178 of FIG. 1). According to an embodiment, the electronic device 101 may exclude at least one (e.g., the connector hole 309) of the components or may add other components. Each module herein may include circuitry.

According to an embodiment, the display 301 may be visually revealed through, e.g., a majority portion of the front plate 302. According to an embodiment, at least a portion of the display 301 may be exposed through the front plate 302 forming the front surface 310A and the first edge areas 310D. According to an embodiment, the edge of the display 301 may be formed to be substantially the same in shape as an adjacent outer edge of the front plate 302. According to another embodiment (not shown), the interval between the outer edge of the display 301 and the outer edge of the front plate 302 may remain substantially even to give a larger area of exposure the display 301.

According to an embodiment, the surface (or the front plate 302) of the housing 310 may include a screen display area formed as the display 301 is visually exposed. For example, the screen display area may include the front surface 310A and first edge areas 310D.

According to another embodiment (not shown), a recess or opening may be formed in a portion of the screen display area (e.g., the front surface 310A or the first edge area 310D) of the display 301, and at least one or more of the audio module 314, sensor module (not shown), light emitting device (not shown), and camera module 305 (e.g., including cameral circuitry) may be aligned with the recess or opening. According to another embodiment (not shown), at least one or more of the audio module 314, sensor module (not shown), camera module 305, fingerprint sensor (not shown), and light emitting device (not shown) may be included on the rear surface of the screen display area of the display 301. According to an embodiment (not shown), the display 301 may be disposed to be coupled with, or adjacent, a touch detecting circuit, a pressure sensor capable of measuring the strength (pressure) of touches, and/or a digitizer for detecting a magnetic field-type stylus pen. According to an embodiment, at least part of the key input device 317 may be disposed in the first edge areas 310D and/or the second edge areas 310E.

According to an embodiment, the audio modules 303, 307, and 314 may include, e.g., a microphone hole 303 and speaker holes 307 and 314. The microphone hole 303 may have a microphone inside to obtain external sounds. According to an embodiment, there may be a plurality of microphones to be able to detect the direction of a sound. The speaker holes 307 and 314 may include an external speaker hole 307 and a phone receiver hole 314. In some embodiments, the speaker holes 307 and 314 and the microphone hole 303 may be implemented as a single hole, or a speaker may be included without the speaker holes 307 and 314 (e.g., a piezo speaker). The audio modules 303, 307, and 314 are not limited to the above-described structure. Depending on the structure of the electronic device 101, various design changes may be made--e.g., only some of the audio modules may be mounted, or a new audio module may be added.

According to an embodiment, the sensor modules (not shown) may generate an electrical signal or data value corresponding to an internal operating state or external environmental state of the electronic device 101. The sensor modules (not shown, including sensing circuitry) may include a first sensor module (e.g., a proximity sensor) and/or a second sensor module (e.g., a fingerprint sensor) disposed on the front surface 310A of the housing 310 and/or a third sensor module (e.g., an HRM sensor) and/or a fourth sensor module (e.g., a fingerprint sensor) disposed on the rear surface 310B of the housing 310. In an embodiment (not shown), the fingerprint sensor may be disposed on the rear surface 310B as well as on the front surface 310A (e.g., the display 301) of the housing 310. The electronic device 101 may include a sensor module not shown, e.g., at least one of a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, or an illuminance sensor. The sensor modules are not limited to the above-described structure. Depending on the structure of the electronic device 101, various design changes may be made- -e.g., only some of the sensor modules may be mounted, or a new sensor module may be added.

According to an embodiment, the camera modules 305, 312, and 313 may include a first camera module 305 disposed on the first surface 310A of the electronic device 101, and a rear camera device 312 and/or a flash 313 disposed on the rear surface 310B. The camera modules 305 and 312 may include one or more lenses, an image sensor, and/or an image signal processor. The flash 313 may include, e.g., a light emitting diode (LED) or a xenon lamp. According to an embodiment, two or more lenses (an infrared (IR) camera, a wide-angle lens, and a telescopic lens) and image sensors may be disposed on one surface of the electronic device 101. The camera modules 305, 312, and 313 are not limited to the above-described structure. Depending on the structure of the electronic device 101, various design changes may be made--e.g., only some of the camera modules may be mounted, or a new camera module may be added.

According to an embodiment, the electronic device 101 may include a plurality of camera modules (e.g., a dual camera or triple camera) having different attributes (e.g., angle of view) or functions. For example, a plurality of camera modules 305 and 312 including lenses having different angles of view may be configured, and the electronic device 101 may control to change the angle of view of the camera modules 305 and 312 performed by the electronic device 101 based on the user's selection. At least one of the plurality of camera modules 305 and 312 may form, for example, a wide-angle camera and at least another of the plurality of camera modules may form a telephoto camera. Similarly, at least one of the plurality of camera modules 305 and 312 may be a front camera and at least another of the plurality of camera modules may be a rear camera. Further, the plurality of camera modules 305 and 312 may include at least one of a wide-angle camera, a telephoto camera, and an infrared (IR) camera (e.g., a time of flight (TOF) camera, a structured light camera). According to an embodiment, the IR camera may be operated as at least a portion of the sensor module. For example, the TOF camera may be operated as at least a portion of a sensor module (not shown) for detecting the distance to the subject.

According to an embodiment, the key input device 317 may be disposed on the side surface 310C of the housing 310. According to an embodiment, the electronic device 101 may exclude all or some of the above-mentioned key input devices 317 and the excluded key input devices 317 may be implemented in other forms, e.g., as soft keys, on the display 301. According to an embodiment, the key input device may include the sensor module disposed on the second surface 310B of the housing 310.

According to an embodiment, the light emitting device may be disposed on, e.g., the front surface 310A of the housing 310. The light emitting device (not shown) may provide, e.g., information about the state of the electronic device 101 in the form of light. According to another embodiment, the light emitting device (not shown) may provide a light source that interacts with, e.g., the front camera module 305. The light emitting device (not shown) may include, e.g., an light emitting device (LED), an infrared (IR) LED, and/or a xenon lamp.

According to an embodiment, the connector holes 308 and 309 may include, e.g., a first connector hole 308 for receiving a connector (e.g., a universal serial bus (USB) connector) for transmitting or receiving power and/or data to/from an external electronic device and/or a second connector hole (e.g., an earphone jack) 309 for receiving a connector for transmitting or receiving audio signals to/from the external electronic device.

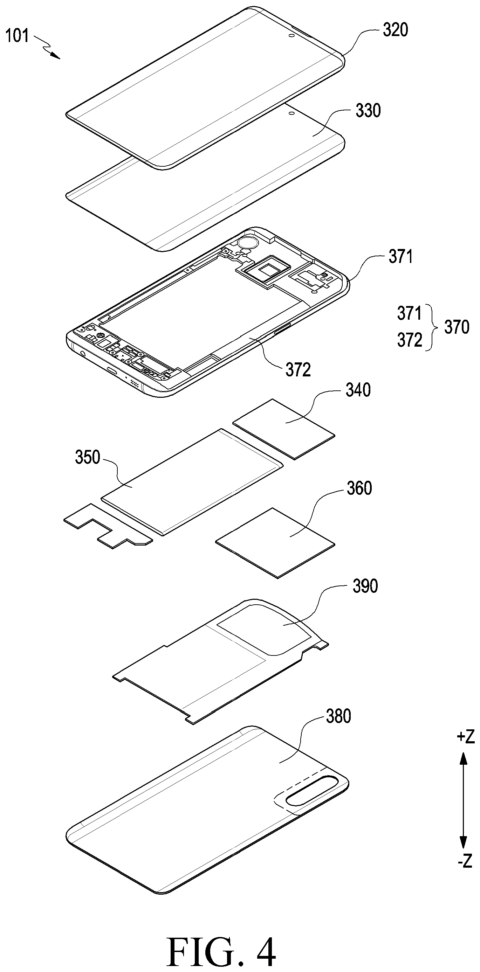

According to an embodiment, at least part of at least one of the camera modules 305 and 312 and/or some of the sensor modules (not shown) may be disposed to be exposed to the outside through at least a portion of the display 301. For example, the camera module 305 may include a punch hole camera disposed inside a hole or recess formed in the rear surface of the display 301. According to an embodiment, the camera module 312 may be disposed inside the housing 310 so that the lens is exposed to the second surface 310B of the electronic device 101. For example, the camera module 312 may be disposed on a printed circuit board (e.g., the printed circuit board 340 of FIG. 4).

According to an embodiment, the camera module 305 and/or the sensor module may be disposed to contact the external environment through a transparent area from the internal space of the electronic device 101 to the front plate 302 of the display 301. Further, some sensor module (e.g., see sensor module 176 in Fig. 1) may be disposed to perform its functions without being visually exposed through the front plate 302 in the internal space of the electronic device.

FIG. 4 is an exploded perspective view illustrating an electronic device according to various example embodiments of the disclosure.

Referring to FIG. 4, according to various embodiments, an electronic device 101 (e.g., the electronic device 101 of FIGS. 1 to 3) may include a supporting bracket 370, a front plate 320 (e.g., the front plate 302 of FIG. 2), a display module 330 (e.g., including the display 301 of FIG. 2), a printed circuit board 340 (e.g., a PCB, flexible PCB (FPCB), or rigid flexible PCB (RFPCB)), a battery 350 (e.g., the battery 189 in FIG. 1), a second supporting member 360 (e.g., a rear structure), an antenna (not shown) (e.g., the antenna module 197 of FIG. 1), and a rear plate 380 (e.g., the rear plate 311 of FIG. 2). The supporting bracket 370 of the electronic device 101 according to an embodiment may include a side bezel structure 371 (e.g., the side bezel structure 318 of FIG. 2) and a first supporting member 372. The rear plate 380 may be considered part of the housing.

According to an embodiment, the electronic device 101 may exclude at least one (e.g., the first supporting member 372 or second supporting member 360) of the components or may add other components. At least one of the components of the electronic device 101 may be the same or similar to at least one of the components of the electronic device 101 of FIG. 2 or 3 and no duplicate description is made below.

According to various embodiments, the first supporting member 372 may be disposed inside the electronic device 101 to be connected with the side bezel structure 371 or integrated with the side bezel structure 371. The first supporting member 372 may be formed of, e.g., a metal and/or non-metallic material (e.g., polymer). The display module 330, including a display, may be joined onto one surface of the first supporting member 372, and the printed circuit board 340 may be joined onto the opposite surface of the first supporting member 372.

According to various embodiments, at least one processor including processing circuitry, a memory, and/or an interface may be mounted on the printed circuit board 340. The processor may include one or more of, e.g., a central processing unit, an application processor, a graphic processing device, an image signal processing, a sensor hub processor, or a communication processor. According to various embodiments, the printed circuit board 340 may include a flexible printed circuit board type radio frequency cable (FRC). For example, the printed circuit board 340 may be disposed on at least a portion of the first supporting member 372 and may be electrically connected with an antenna module (e.g., the antenna module 197 of FIG. 1, including an antenna) and a communication module (e.g., the communication module 190 of FIG. 1, including communication circuitry).

According to an embodiment, the memory may include, e.g., a volatile or non-volatile memory.

According to an embodiment, the interface may include, for example, a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

According to an embodiment, the battery 350 (e.g., 189 in Fig. 1) may be a device for supplying power to at least one component of the electronic device 101. The battery 350 may include, e.g., a primary cell which is not rechargeable, a secondary cell which is rechargeable, or a fuel cell. At least a portion of the battery 350 may be disposed on substantially the same plane as the printed circuit board 340. The battery 350 may be integrally or detachably disposed inside the electronic device 101.

According to various embodiments, the second supporting member 360 (e.g., a rear structure) may be disposed between the printed circuit board 340 and the antenna. For example, the second supporting member 360 may include one surface to which at least one of the printed circuit board 340 and the battery 350 is coupled, and another surface to which the antenna is coupled.

According to an embodiment, the antenna 390 may be disposed between the rear plate 380 and the battery 350. The antenna may include, e.g., a near-field communication (NFC) antenna, a wireless charging antenna, and/or a magnetic secure transmission (MST) antenna. The antenna may perform short-range communication with, e.g., an external device or may wirelessly transmit or receive power necessary for charging. According to an embodiment, an antenna structure may be formed by a portion or combination of the side bezel structure 371 and/or the first supporting member 372.

According to various embodiments, the rear plate 380 may form at least a portion of the rear surface (e.g., the second surface 310B of FIG. 3) of the electronic device 101.

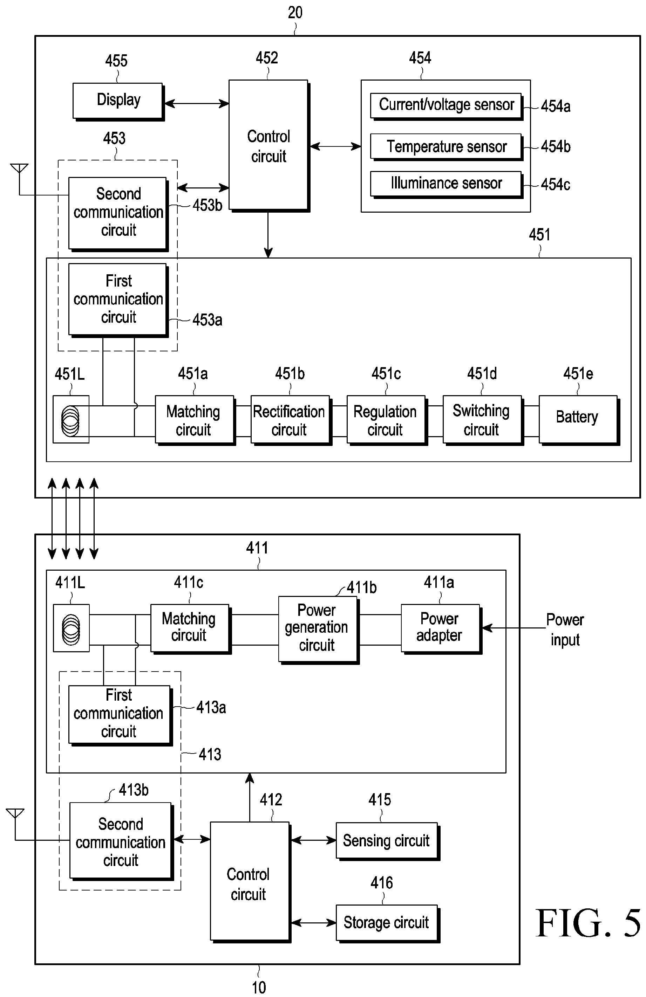

FIG. 5 is a block diagram illustrating a wireless charging system according to various example embodiments of the disclosure.

Referring to FIG. 5, according to an embodiment, a wireless charging system may include an external electronic device 10 for transmitting wireless power and a wireless power transmission/reception device 20 (e.g., the electronic device 101 of FIG. 1) for receiving the transmitted wireless power.

According to an embodiment of the disclosure, the external electronic device 10 may include a circuit board including various circuits. The circuit board may include a power transmission/reception circuit 411, a control circuit 412, a communication circuit 413, a sensing circuit 415, and a storage circuit 416. The wireless power transmission/reception device 20 may include a power transmission/reception circuit 451, a control circuit 452, a communication circuit 453 (including first and second communication circuits 453a and 453b), a sensing circuit 454, and a display 455.

According to various embodiments, the power transmission/reception circuit 411 may provide power required by the wireless power transmission/reception device 20 to receive power, and may include a loop coil 411L formed as a conductive pattern. The power transmission/reception circuit 411 may be provided to wirelessly transmit power to the wireless power transmission/reception device 20 through the loop coil 411L. Here, the power transmission/reception circuit 411 may receive power in the form of a DC or AC signal from the outside (e.g., power input) and may supply the received power, in the form of an AC signal, to the wireless power transmission/reception device 20. For example, when the power transmission/reception circuit 411 receives power in the form of a DC signal from the outside, the power transmission/reception circuit 411 may convert the power of the DC signal into an AC signal by a power inverter and supply the AC signal to the wireless power transmission/reception device 20. As another example, when the power transmission/reception circuit 411 wirelessly receives power, as an AC signal, from the outside, the power transmission/reception circuit 411 may convert the power of the AC signal into a DC signal by a rectifier. The rectified power may be transferred to a charger or PMIC for charging the battery.

According to various embodiments, the power transmission/reception circuit 411 may provide an AC signal, as a frequency resonance signal, to the wireless power transmission/reception device 20. The power transmission/reception circuit 411 may include a loop coil 411L formed as a conductive pattern and may transmit or receive a resonance signal having a predetermined frequency, generated as current is applied to the loop coil 411L, by an electromagnetic induction scheme or resonance scheme. The power transmission/reception circuit 411 may additionally include a first communication circuit 413a (e.g., a resonance circuit) and may perform communication (e.g., data communication) in an in-band manner using the frequency resonance signal generated by the loop coil 411L. The first communication circuit 413a is described in more detail in connection with the communication circuit 413 described below. When the power transmission/reception circuit 411 is implemented as a resonance circuit, the inductance L of the loop coil 411L of the resonance circuit may be changeable.

Further, the power transmission/reception circuit 411 may be implemented in the form of a power reception interface to receive power from the outside and supply it to other components. The power transmission/reception circuit 411 may further include a power adapter 411a, a power generation circuit 411b, and a matching circuit 411c, in addition to the loop coil 411L.

According to various embodiments, the power adapter 411a may receive AC or DC power from the outside or receive a power signal of a battery device to output a DC signal having a preset voltage value. The voltage value of the DC signal output from the power adapter 411a may be controlled by a control circuit 412. The DC signal output from the power adapter 411a may be transferred to the power generation circuit 411b.

According to various embodiments, the power generating circuit 411b may convert the DC signal output from the power adapter 411a into an AC signal and output the AC signal. The power generation circuit 411b may include a predetermined amplifier (not shown). If the DC signal input through the power adapter 411a is less than a preset strength, the amplifier may amplify the DC signal to the preset strength. Further, the power generation circuit 411b may further include a circuit that converts the DC current input from the power adapter 411a into AC current based on a control signal input from the control circuit 412. For example, the power generation circuit 411b may convert the DC signal into an AC signal through a predetermined inverter. Alternatively, the power generation circuit 411b may further include a gate driving device (not shown), and the gate driving device may convert the DC signal into an AC signal by controlling the on/off of the DC signal.

According to various embodiments, the matching circuit 411c may perform an impedance control operation. For example, if the AC signal output from the power generation circuit 411b is transferred to the loop coil 411L, an electromagnetic field may be formed in the loop coil 411L by the AC signal. In this case, the matching circuit 411c may adjust the frequency band of the received electromagnetic field signal through impedance adjustment. The matching circuit 411c may adjust the impedance seen from, e.g., the matching circuit 411c, transmitted to the wireless power transmission/reception device 20 through the loop coil 411L by such impedance adjustment, controlling the output signal power to have high output power. The matching circuit 411c may adjust impedance based on the control of the control circuit 412. The matching circuit 411c may include at least one of an inductor (e.g., coil), a capacitor, or a switching device. The control circuit 412 may control the state of connection with at least one of the inductor and capacitor through the switching device, thereby allowing the matching circuit 411c to performing the operation of changing impedance.

The power transmission/reception circuit 411 is not limited thereto, and it will be appreciated by one of ordinary skill in the art that any means capable of transmitting/receiving electromagnetic waves may be included.

According to various embodiments, the sensing circuit 415 may sense a change in the amount of power to be transmitted to the wireless power transmission/reception device 20. The external electronic device 10 may generate an amount of transmission power to be transmitted to the wireless power transmission/reception device 20 in response to the magnitude of the current/voltage applied to the loop coil 411L, and the sensing circuit 415 may sense the amount of transmission power. In the external electronic device 10, the amount of power to be transmitted may be changed according to a change in the current/voltage of the signal output through the loop coil 411L. For example, as the magnitude of the current/voltage applied to the loop coil 411L increases, the amount of transmission power to be transmitted may increase and, as the magnitude of the current/voltage applied to the loop coil 411L decreases, the amount of power to be transmitted may be reduced.

According to an embodiment, the sensing circuit 415 (e.g., a temperature sensor (thermistor)) may sense a change in the temperature of the external electronic device 10. The sensing circuit 415 may sense a change in temperature due to the heat that may be generated from the external electronic device 10 upon generating the power to be transmitted by the power transmission/reception circuit 411 or upon transmitting the generated power to the wireless power transmission/reception device 20. For example, the sensing circuit 415 may measure at least one of the internal temperature and external temperature of the external electronic device 10. According to an embodiment, the sensing circuit 415 may include at least one of a current sensor, a voltage sensor, and a temperature sensor. The current sensor may be implemented as, e.g., a charge counter (e.g., a Coulomb counter), but there is no limitation on the aspect of implementation. The voltage sensor is not limited in type as long as it is a voltage meter capable of measuring the voltage of the wireless power transmission/reception device 20.

According to various embodiments, the control circuit 412 may control the overall operation of the external electronic device 10. The control circuit 412 may control the overall operation of the external electronic device 10 using an algorithm, a program, or an application required for control, stored in the storage circuit 416. Further, the control circuit 412 may control to wirelessly transmit power to the power reception device 101 through the power transmission/reception circuit 411. The control circuit 412 may control to wirelessly receive information from the power reception device 101 through the communication circuit 413.

According to various embodiments, the communication circuit (the first communication circuit 413a, the second communication circuit 413b) (e.g., the interface 177 or communication module 190 of FIG. 1, each including circuitry) may perform communication with the wireless power transmission/reception device 20 in a predetermined scheme. The communication circuit 413 may perform data communication with the communication circuit 453 of the wireless power transmission/reception device 20.

Meanwhile, the communication circuit 413 may also transmit a signal for information about the external electronic device 10 to the wireless power transmission/reception device 20. Here, the communication circuit 413 may unicast, multicast, or broadcast the signal. Further, the communication circuit 413 may transmit a charging function control signal to control the charging function of the wireless power transmission/reception device 20. The charging function control signal may be a control signal that enables or disables the charging function by controlling the power transmission/reception circuit 451 of a specific electronic device (e.g., the wireless power transmission/reception device 20).

Meanwhile, the communication circuit 413 may receive or transmit signals from/to another wireless power transmission device (not shown) as well as the wireless power transmission/reception device 20.

According to an embodiment, the communication circuit 413 may include at least one of a first communication circuit 413a that may be, together with the power transmission/reception circuit 411, implemented as a single piece of hardware to allow the external electronic device 10 to perform communication in an in-band type or a second communication circuit 413b that may be implemented as hardware different from the power transmission/reception circuit 411 to allow the external electronic device 10 to perform communication in an out-of-band type.

For example, when the communication circuit 413 includes the first communication circuit 413a that may perform communication in the in-band type, the first communication circuit 413a may receive a preset frequency and signal level of electromagnetic field signal through the loop coil 411L of the power transmission/reception circuit 411. In this case, the control circuit 412 may decode the preset frequency and signal level of electromagnetic field signal and extract the information received from the wireless power transmission/reception device 20. Further, the first communication circuit 413a may apply a signal for the information to be transmitted to the loop coil 411L of the power transmission/reception circuit 411. For example, the first communication circuit 413a may add the signal for the information to be transmitted to the signal output from the matching circuit 411c. In this case, the control circuit 412 may control to change the connection state with at least one of the inductor and the capacitor of the matching circuit 411c through on/off control of the switching device included in the matching circuit 411c, and the control circuit 412 may perform on/off keying encoding. The magnitude (e.g., the voltage at the output end of the rectifier) of the power output through the loop coil 451L of the wireless power transmission/reception device 101 may be changed in response to the on/off control, and the wireless power transmission/reception device 101 may decode it in an on/off keying scheme, obtaining information.

For example, when the communication circuit 413 includes the second communication circuit 413b capable of performing communication in an out-of-band type, the second communication circuit 413b may perform communication with the communication circuit 453 (e.g., the second communication circuit 453b) of the wireless power transmission/reception device 20 using at least one of the NFC, Zigbee communication, infrared communication, visible light communication, Bluetooth communication, or Bluetooth low energy (BLE) scheme.

Meanwhile, the above-described communication scheme of the communication circuit 413 is merely an example, and the scope of embodiments herein is not limited to a specific communication scheme performed by the communication circuit 413.

Further, the communication circuit 413 may transmit a charging function control signal to control the charging function of the wireless power transmission/reception device 20. The charging function control signal may be a control signal that enables or disables the charging function by controlling the power transmission/reception circuit 451 of the wireless power transmission/reception device 20.

The communication circuit 413 may receive or transmit signals from/to another wireless power transmission device (not shown) as well as the wireless power transmission/reception device 20. For example, the communication circuit 413 may be configured as hardware different from that of the power transmission/reception circuit 411 so that the external electronic device 10 may perform communication in an out-of-band type. However, this is an example, and the power transmission/reception circuit 411 and the communication circuit 413 may be implemented as a single piece of hardware so that the external electronic device 10 may perform communication in an in-band type.

The external electronic device 10 and the wireless power transmission/reception device 20 may transmit/receive various signals through their respective communication circuits 413 and 453.

Further, according to various embodiments, the external electronic device 10 may be a portable terminal device including the power transmission/reception circuit 411 and a battery. Accordingly, the external electronic device 10, which is the portable terminal device, may transmit power stored in the battery, as wireless power, to the wireless power transmission/reception device 20. Further, according to various embodiments, the external electronic device 10 is not limited to a wireless charger or a portable terminal, and may be various electronic devices including the power transmission/reception circuit 411.

Meanwhile, according to an embodiment, the power transmission/reception circuit 451 of the wireless power transmission/reception device 20 may receive power from the power transmission/reception circuit 411 of the external electronic device 10. The power transmission/reception circuit 451 may be implemented in the form of a power reception interface to receive power from the outside. The power transmission/reception circuit 451 may include a loop coil 451L formed as a conductive pattern. The power transmission/reception circuit 451 may receive, through the loop coil 451L, the wireless power in the form of an electromagnetic wave generated in response to the current/voltage applied to the loop coil 411L of the power transmission/reception circuit 411 of the external electronic device 10. For example, the power transmission/reception circuit 451 may receive, from the power transmission/reception circuit 411 of the external electronic device 10, signal power supplied to the loop coil 451L of the power transmission/reception circuit 451 adjacent as the AC waveform of power applied to the loop coil 411L of the power transmission/reception circuit 411 generates induced power. For example, the power transmission/reception circuit 451 may receive, through the loop coil 451L, the wireless signal power in the form of an electromagnetic wave generated in response to the current/voltage applied to the loop coil 411L of the power transmission/reception circuit 411 of the external electronic device 10.

The power transmission/reception circuit 451 may further include a matching circuit 451a, a rectification circuit 451b, a regulation circuit (regulator) 451c, a switching circuit 451d, and a battery 451e, as well as the loop coil 451L.

The matching circuit 451a may perform an impedance control operation. For example, the signal power transmitted through the loop coil 411L of the external electronic device 10 may be transferred to the loop coil 451L, forming an electromagnetic field. In this case, the matching circuit 451a may adjust the frequency band of the formed electromagnetic field signal, adjusting the impedance as seen from the matching circuit 451a. The matching circuit 451a may control to allow the input power received from the external electronic device 10 through the loop coil 451L to have high efficiency and high output by such impedance adjustment. The matching circuit 451a may adjust impedance based on the control of the control circuit 452. The matching circuit 451a may include at least one of an inductor (e.g., coil), a capacitor, and a switching device. The control circuit 452 may control the state of connection with at least one of the inductor and capacitor through the switching device, thereby performing an impedance control operation.

The rectification circuit 451b may rectify the wireless signal power received by the loop coil 451L into a DC signal and may be implemented in the form of a rectifier circuit including, e.g., bridged diodes.

The regulation circuit 451c may convert the rectified signal strength into a preset strength. The regulation circuit 451c may include a predetermined DC/DC converter (not shown) (e.g., a buck converter). For example, the regulation circuit 451c may convert the rectified power so that the voltage at the output end is 5V. Meanwhile, a minimum value or maximum value of the voltage that may be applied may be set at the front end of the regulation circuit 451c.

The switching circuit 451d may connect the regulation circuit 451c and the battery 451e. The switching circuit 451d may maintain the on/off state according to the control of the control circuit 452.

The battery 451e may be charged by receiving power input from the regulation circuit 451c when the switching circuit 451d is in an on state.

The sensing circuit 454 may sense a change in the state of charge of the wireless power reception device 101. For example, the sensing circuit 454 may periodically or aperiodically measure the current/voltage value of the signal received by the loop coil 451L through a predetermined current/voltage sensor 454a. The wireless power reception device 101 may calculate the amount of reception power received by the external wireless power reception device 101 based on the measured current/voltage.

The sensing circuit 454 may sense a change in the charging environment of the wireless power transmission/reception device 20. For example, the sensing circuit 454 may periodically or aperiodically measure at least one of the internal temperature or external temperature of the wireless power reception device 101 through a predetermined temperature sensor 454b. The sensing circuit 454 may periodically or aperiodically measure the ambient illuminance (brightness) of the wireless power transmission/reception device 20 through a predetermined illuminance sensor 454c. The sensing circuit 454 is not limited to the above-described sensors (e.g., the current/voltage sensor 454a, the temperature sensor 454b, and/or the illuminance sensor 454c), and at least one sensor may be omitted or another sensor may be further included.

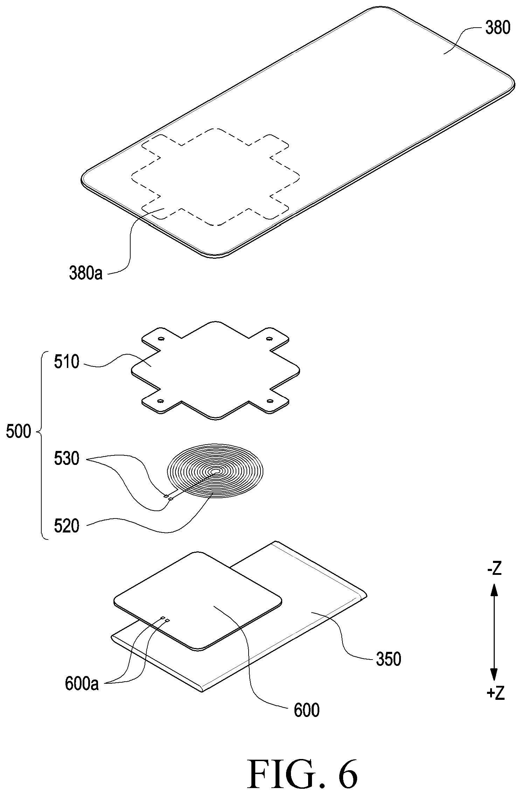

FIG. 6 is a perspective view illustrating a stack structure of an electronic device according to one of various example embodiments of the disclosure.

According to various embodiments, the electronic device (e.g., the electronic device 101 of FIGS. 1 to 4) may include a rear plate 380 (e.g., part of the housing), a wireless charging structure 500, a circuit board 600, and a battery 350. The wireless charging structure 500 may include an insert portion 510 and a wireless charging coil 520.

The structure of the rear plate 380, the wireless charging structure 500, and the battery 350 of FIG. 6 may be identical in whole or part to the structure of the rear plate 380, the antenna 390, and the battery 350 of FIG. 4.

According to various embodiments, an inner surface (e.g., the surface facing in the +Z-axis direction) of the rear plate 380 may include a recess 380a for disposing at least a portion of the wireless charging structure 500. For example, the recess 380a may be provided in a shape corresponding to the wireless charging structure 500, and the edge portion of the recess 380a may be provided in a shape, such as a step or an inclined surface, for physically coupling with a portion of the wireless charging structure 500.

According to an embodiment, the rear plate 380 is for forming an exterior cover of the electronic device 101 and may include a polymer material (e.g., resin). The polymer material may have a transparent and/or opaque color. For example, when the rear plate 380 is formed of a transparent polymer material, the rear plate 380 may be subjected to post-treatment, such as painting and/or deposition, to prevent or reduce the internal components from being viewed. According to an embodiment, the polymer material may include a thermoplastic resin that may be molded by an injection machine. The polymer material may further include an inorganic material (e.g., glass fiber or Talc) for reinforcing physical properties. Further, the polymer material may contain other dyes and/or pigments having various colors.

According to various embodiments, the wireless charging structure 500 may include an insert portion 510, at least one wireless charging coil 520, and terminals 530 formed at an end of the at least one wireless charging coil 520. The wireless charging structure 500 may be fixed in the recess 380a formed in the inner surface of the rear plate 380.

According to an embodiment, the insert portion 510 may be formed of a second material different from the first material of the rear plate 380. The insert portion 510 may include a thermosetting polymer material (e.g., an epoxy resin). The insert portion 510 may be cured after being disposed to surround at least a portion of the wireless charging coil 520 and the terminals 530 before being cured. After cured, the insert portion 510 may be combined with the wireless charging coil 520 and the terminals 530 to form an integrated wireless charging structure 500. For example, the wireless charging coil 520 and the terminals 530 may be molded together with the insert portion 510 before cured and then have a woven structure with the insert portion 510 which is gradually cured over time by heat, thus forming a strongly combined, integrated wireless charging structure 500.

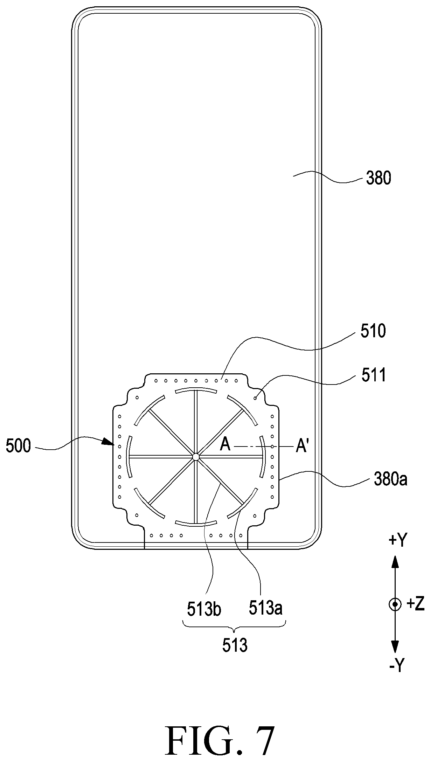

According to an embodiment, the insert portion 510 may be formed to have a larger size (e.g., area) than the wireless charging coil 520 to be able to surround at least a portion of the wireless charging coil 520. The insert portion 510 may include a guide slot (e.g., the guide slot 513 of FIG. 7) to stably fix the wireless charging coil 520 while preventing or reducing eccentricity.

According to an embodiment, the wireless charging coil 520 may form one layer wound in a first shape designated by a first number of turns. For example, the wireless charging coil 520 formed of one coil may be wound in the same direction to provide current flow in the same direction. The single coil may be provided in such a form in which the inner center is open, and the lines (e.g., terminals 530) extending from the inner diameter end and/or outer diameter end may be electrically connected with the circuit board 600. As another example, a plurality of layers of the wireless charging coil 520 may be stacked on their respective conductive layers of a flexible printed circuit board (not shown) and may be electrically connected via vias. As another example, the wireless charging coil 520 may include a plurality of coils which may be implemented in different numbers of turns and different shapes. According to an embodiment, at least one coil of the wireless charging coil 520 may be a coil conforming to the wireless power consortium (WPC) standard. As another example, a ferrite composite sheet (not shown) for concentrating magnetic flux may be attached to the center of the wireless charging coil 520, and the composite sheet may be configured in a circular shape to correspond to the shape of the wireless charging coil 520.

According to an embodiment, the terminals 530 are conductive lines extending from the wireless charging coil 520 and, at the end thereof, a structure (e.g., at least one of a coaxial cable connector, board-to-board (B-to-B), C-clip, or short pad) for electrically connecting to the circuit board 600 may be disposed. For example, the terminals 530 extending from the wireless charging coil 520 may be connected to the connection portion 600a of the circuit board 600 to receive power.

According to various embodiments, the circuit board 600 may be positioned between the wireless charging structure 500 and the battery 350 and may include the connection portion 600a electrically connected to the terminals 530 of the wireless charging structure 500. The connection portion 600a of the circuit board 600 may be a structure (e.g., at least one of a coaxial cable connector, board-to-board (B-to-B), C-clip, or short pad) for electrically connecting to the terminals 530 of the wireless charging structure 500. According to an embodiment, the circuit board 600 may be a main printed circuit board (e.g., the printed circuit board 340 of FIG. 4) on which a wireless communication circuit is mounted. According to another embodiment, the circuit board 600 may be a separate board that is disposed adjacent to the wireless charging structure 500 to provide power or electrically connect the main printed circuit board (e.g., the printed circuit board 340 of FIG. 4) with the wireless charging structure 500.

According to various embodiments, the electronic device 101 may include a magnetic plate (not shown) for the wireless charging structure 500. The magnetic plate may be stacked in an area where the wireless charging coil 520 is disposed, enhancing the charging efficiency of the wireless charging coil 520 and reducing surface heat generation. For example, by disposing a magnetic plate having magnetic flux-inducing magnetic properties on the rear surface (e.g., the surface facing in the -Z axis) of the wireless charging coil 520, it is possible to increase the amount of magnetic flux introduced and limit the interference by the surrounding conductive material. The magnetic plate may be coupled together with the wireless charging coil 520 and the insert portion 510 and be formed as a portion of the wireless charging structure 500 or be separately formed and disposed in an area adjacent to the wireless charging structure 500. According to an embodiment, the electronic device 101 may further include a heat dissipation sheet (not shown) to mitigate surface heat generated by the wireless charging coil 520. The heat dissipation sheet may be stacked with the wireless charging coil 520 and may include a graphite sheet.

FIG. 7 is a view illustrating a wireless charging structure disposed inside a rear plate of an electronic device according to various example embodiments of the disclosure.

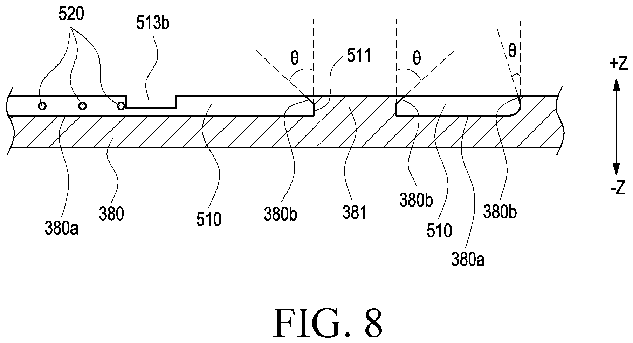

FIG. 8 is a cross-sectional view illustrating a wireless charging structure and a rear plate taken along A-A' of the electronic device of FIG. 7, according to various example embodiments of the disclosure.

According to various embodiments, the electronic device (e.g., the electronic device 101 of FIGS. 1 to 4) may include a rear plate 380 and a wireless charging structure 500.

The structure of the rear plate 380 and the wireless charging structure 500 of FIGS. 7 and 8 may be identical in whole or part to the structure of the rear plate 380 and the wireless charging structure 500 of FIG. 6.

According to various embodiments, the wireless charging structure 500 may include an insert portion 510 and at least one wireless charging coil 520. The wireless charging structure 500 may be fixed in a recess (e.g., the recess 380a of FIG. 6) formed in the inner surface (e.g., the surface facing in the +Z-axis direction) of the rear plate 380.

According to various embodiments, the insert portion 510 of the wireless charging structure 500 may include a guide slot 513 for stably guiding the position of the wireless charging coil 520. For example, before the insert portion 510 is cured, the position of the wireless charging coil 520 may be aligned by the guide slot 513 and, with the wireless charging coil 520 remaining aligned, the insert portion 510 may form a woven structure along with the wireless charging coil 520 and be cured. The guide slot 513 of the insert portion 510 may maintain its shape before and after cured.

According to various embodiments, the guide slot 513 of the insert portion 510 may include a first guide slot 513a for guiding the outer line of the wireless charging coil 520 not to be moved or shaken and a second guide slot 513b disposed adjacent to the first guide slot 513a to guide the wireless charging coil 520 to overall remain at a designated height from one surface of the insert portion 510.

According to an embodiment, the first guide slot 513a may be disposed on one surface of the insert portion 510. The first guide slot 513a may form a curved structure and may be positioned to fully or partially surround an outer portion (e.g., a layer wound with the outermost line) of the wireless charging coil 520. For example, the first guide slot 513a may be implemented in a closed loop shape corresponding to the circumference of the wireless charging coil 520. As another example, the first guide slot 513a may be implemented in a shape partially cut from the one closed loop shape. For example, the first guide slot 513a may overall correspond to the closed loop shape of the wireless charging coil 520 and may include a plurality of separated curved slots. When viewed from above the insert portion 510 and the wireless charging coil 520 (e.g., when viewed from the +Z-axis direction to the -Z-axis direction), the first guide slot 513a may restrict the wireless charging coil 520 so that its center is fixed and is not escaped off to the left/right or up/down, thus preventing or reducing any possible deviation of the eccentricity of the wireless charging coil 520.

According to an embodiment, the second guide slot 513b may be disposed on one surface of the insert portion 510. The second guide slot 513b may form a linear structure and may be positioned between one surface (e.g., one surface facing in the -Z axis) of the insert portion 510 and the wireless charging coil 520. As the wireless charging coil 520 is overall disposed on the second guide slot 513b, the wireless charging coil 520 may form the same height from one surface of the insert portion 510. According to an embodiment, the second guide slot 513b may include a plurality of slots which may be disposed radially from the center of the wireless charging coil 520. For example, each of the slots of the second guide slot 513b may have one linear shape extending from the first guide slot 513a to the center (e.g., the center of the wireless charging coil 520) of the circular first guide slot 513a. A portion of the wireless charging coil 520 may be positioned on the linear shape. As another example, the slots of the first guide slot 513a each have a linear shape and be disposed at designated intervals to overall distribute the load of the wireless charging coil 520 while maintaining the same height. According to various embodiments, the second guide slot 513b according to an embodiment of the disclosure may prevent or reduce the likelihood of the wireless charging coil 520 from deforming in an upper or lower direction or being fixed at an unwanted height and shaped due to the own weight of the wireless charging coil 520 or the thermosetting material of the insert portion 510.

According to various embodiments, the wireless charging structure 500 positioned in the recess 380a of the rear plate 380 may be fixed to the rear plate 380 by the coupled structure. The rear plate 380 and the wireless charging structure 500 may be formed of different materials. Accordingly, the coupled structure of the rear plate 380 and the wireless charging structure 500 may make use of enhanced chemical bonding by using high-adhesion materials to enhance the adhesion between different materials. Further, the coupled structure of the rear plate 380 and the wireless charging structure 500 may use a physical coupling through a structurally woven or fixed structure.

According to an embodiment, in the coupled structure of the rear plate 380 and the wireless charging structure 500, the insert portion 510 of the wireless charging structure 500 may form a receiving portion 511 including at least one hole or recess, and a portion of the rear plate 380 may be formed to include a protrusion 381 to be fitted into the hole or recess. As the insert portion 510 formed of a thermosetting material is gradually cured in the recess 380a of the rear plate 380, a strong bond with the rear plate 380 may be formed.

According to an embodiment, in the coupled structure of the rear plate 380 and the wireless charging structure 500, at least a portion of the edge of the recess 380a (e.g., hole or groove) of the rear plate 380 may form an inversely tapered shape 380b (e.g., a slope shape). In the inversely tapered shape 380b of the recess 380a, the side portion forming the hole or recess has a designated slope (θ), so that the area of the hole or recess may increase from the outside to the inside (e.g., toward the +Z-axis direction). For example, the inversely tapered shape 380b may form the same or different designated slope θ for each edge of the hole or recess. As another example, each of the same or different designated slopes may have a value larger than about 0 degrees and less than or equal to 45 degrees with respect to the +Z axis. As another example, the same or different designated slopes may have a value equal to or larger than 1 degree which is the draft on a normal mold. According to an embodiment, the insert portion 510 formed of a thermosetting material may be gradually hardened within the recess 380a of the rear plate 380 and, after cured, its escape off to the outside may be restricted by the inversely tapered shape 380b of the recess 380a and may thus be strongly bonded with the rear plate 380. However, the inversely tapered shape 380b of the recess 380a may be wholly or partially formed in a portion of the recess 380a and, as coupling between structures, the design may be changed without being tapered.

According to an embodiment, in the coupled structure of the rear plate 380 and the wireless charging structure 500, the recess 380a of the rear plate 380 may reinforce coupling with the wireless charging structure 500 by corrosion treatment. For example, the portion of the recess 380a of the rear plate 380 may be roughened to have surface roughness, so that the surface area of the insert portion 510, substantially in contact with the recess 380a, is increased. The insert portion 510 formed of a thermosetting material is gradually hardened in the recess 380a of the rear plate 380 and be thus strongly bonded with the rear plate 380. The corrosion treatment on the rear plate 380 may include at least one of electric discharge corrosion, chemical corrosion, or sanding (blasting).

According to various embodiments, the coupled structure of the rear plate 380 and the wireless charging structure 500 uses at least one of the structure in which the protrusion 381 of the rear plate 380 is inserted into the receiving portion 511 including at least one hole or recess of the insert portion 510, the structure of the inversely tapered shape 380b of the recess 380a of the rear plate 380, or the structure obtained by performing corrosion treatment on the recess 380a of the rear plate 380 as described above, thereby securing enhanced mechanical properties and reliability for the electronic device 101.

According to various embodiments, when viewing at the inner surface of the rear plate 380 (e.g., when viewed from the +Z-axis direction to the -Z-axis direction), the recess 380a and the wireless charging structure 500 coupled with the recess 380a may be positioned in a lower portion (e.g., the end facing in the -Y-axis direction of the rear plate 380) of the rear plate 380. Most of the area of the wireless charging structure 500 may be positioned on the inner surface of the rear plate 380, and a portion thereof may extend towards the side surface of the rear plate 380. However, the position of the wireless charging structure 500 is not limited thereto. Like the upper end facing in the direction (e.g., the +Y-axis direction) opposite to the lower end of the inner surface of the rear plate 380, a design change may be made to the position where wireless charging is easily performed.

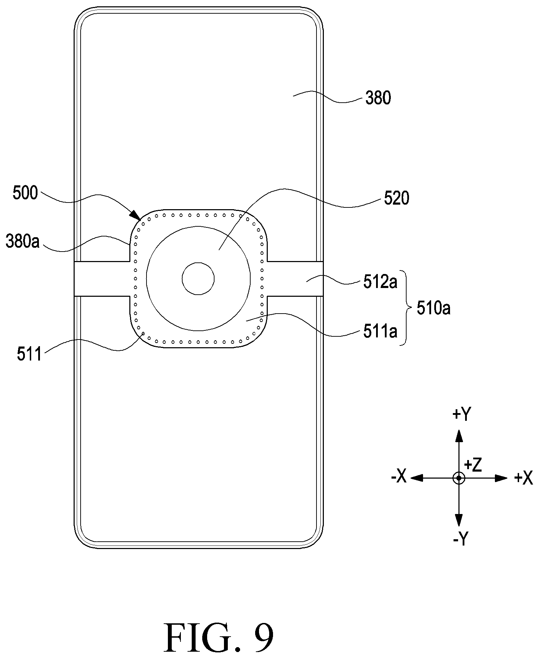

FIG. 9 is a view illustrating a wireless charging structure disposed inside a rear plate of an electronic device according to another example embodiment of the disclosure.

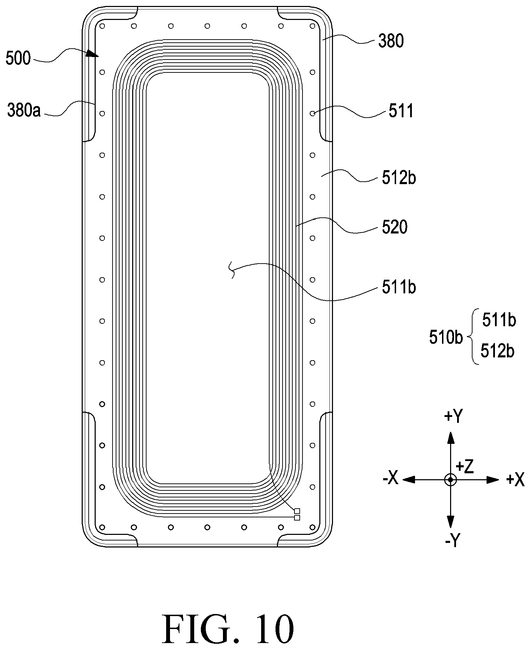

FIG. 10 is a view illustrating a wireless charging structure disposed inside a rear plate of an electronic device according to another example embodiment of the disclosure.

According to various embodiments, the electronic device (e.g., the electronic device 101 of FIGS. 1 to 4) may include a rear plate 380 and a wireless charging structure 500. The wireless charging structure 500 may include insert portions 510a and 510b and a wireless charging coil 520.

The structure of the rear plate 380 and the wireless charging structure 500 of FIGS. 9 and 10 may be identical in whole or part to the structure of the rear plate 380 and the wireless charging structure 500 of FIGS. 6 to 8.

According to various embodiments, the wireless charging structure 500 may include an insert portion 510a or 510b and at least one wireless charging coil 520. The wireless charging structure 500 may be fixed in the recess 380a formed in the inner surface of the rear plate 380. FIGS. 9 and 10 are shown in such a manner that the wireless charging coil 520 is shown which is inside the insert portion 510a or 510b of the wireless charging structure 500.

Referring to FIG. 9, when viewing at the inner surface of the rear plate 380 (e.g., when viewed from the +Z-axis direction to the -Z-axis direction), the recess 380a and the wireless charging structure 500 coupled with the recess 380a may be positioned in a lower portion (e.g., the end facing in the -Y-axis direction of the rear plate 380) of the rear plate 380. Most of the area of the wireless charging structure 500 may be positioned on the inner surface of the rear plate 380, and a portion thereof may extend towards the side surface of the rear plate 380.

According to an embodiment, the insert portion 510a of the wireless charging structure 500 may include a 1-1th area 511a in which the wireless charging coil 520 is disposed and a 2-1th area 512a extending from the 1-1th area 511a. The structure in which the protrusion of the rear plate 380 is inserted into the receiving portion 511 (e.g., a plurality of holes or recesses) of the insert portion 510a may be positioned at the edge of the 1-1th area 511a. The 1-1th area 511a may be formed in an area that may cover the wireless charging coil 520. The 2-1th area 512a may extend from the edge of the 1-1th area 511a to the side surface of the rear plate 380. For example, a portion of the 2-1th area 512a may be designed to extend from one end of the 1-1th area 511a in the X-axis direction, and may extend to a side surface of the rear plate 380. For example, another portion of the 2-1th area 512a may be designed to extend from the other end of the 1-1th area 511a in the -X-axis direction to the side surface of the rear plate 380.

Referring to FIG. 10, when viewing at the inner surface of the rear plate 380 (e.g., when viewed from the +Z-axis direction to the -Z-axis direction), the recess 380a and the wireless charging structure 500 coupled with the recess 380a may be positioned in most of the area of the rear plate 380. Most of the area of the wireless charging structure 500 may be positioned on the inner surface of the rear plate 380, and a portion thereof may extend towards the side surface of the rear plate 380. The wireless charging coil 520 of FIG. 10 may form a closed loop in a larger size than the wireless charging coil 520 of FIG. 9. For example, the wireless charging coil 520 of FIG. 10 may be arranged along the edge of the rear plate 380.

According to an embodiment, the wireless charging structure 500 may include a 1-2th area 511b in which the wireless charging coil 520 is disposed and a 2-2th area 512b extending from the 1-2th area 511b. The structure in which the protrusion of the rear plate 380 is inserted into the receiving portion 511 (e.g., a plurality of holes or recesses) of the insert portion 510b may be positioned at the edge of the 1-2th area 511b. The 1-2th area 511b may be formed in an area that may cover the wireless charging coil 520. The 1-2th area 511b may be formed in a size corresponding to or similar to that of the inner surface of the rear plate 380. The 2-2th area 512b may extend from the edge of the 1-2th area 511b to the side surface of the rear plate 380. For example, a portion of the 2-2th area 512b may be designed to extend from one end of the 1-2th area 511b in the +X-axis direction to the side surface of the rear plate 380. Another portion of the 2-2th area 512b may be designed to extend from one end of the 1-2th area 511b in the -X-axis direction to the side surface of the rear plate 380. Another portion of the 2-2th area 512b may be designed to extend from one end of the 1-2th area 511b in the +Y-axis direction to the side surface of the rear plate 380. Another portion of the 2-2th area 512b may be designed to extend from one end of the 1-2th area 511b in the -Y-axis direction to the side surface of the rear plate 380.

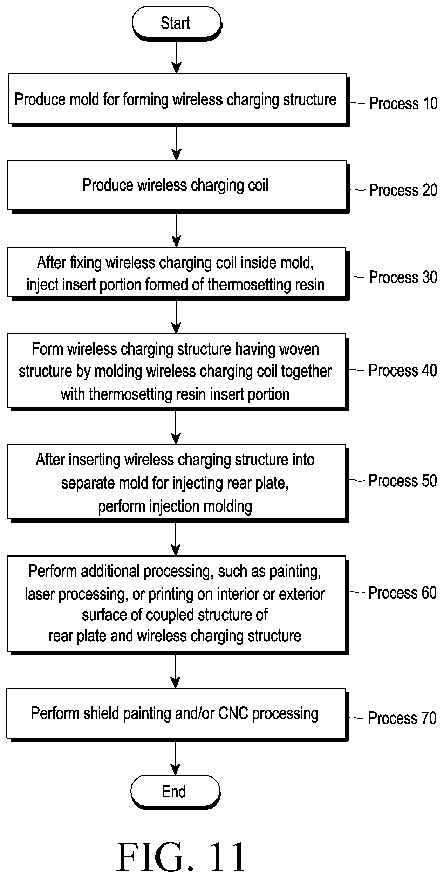

FIG. 11 is a flowchart illustrating a method for manufacturing a wireless charging structure and disposing the wireless charging structure on a rear plate of an electronic device according to various example embodiments of the disclosure.

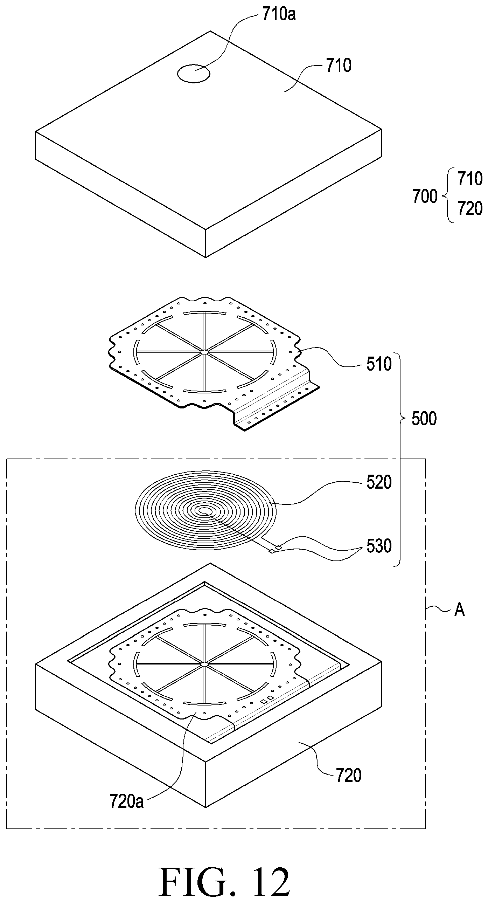

FIG. 12 is a perspective view illustrating a mold for inserting a wireless charging structure and a wireless charging coil according to various example embodiments of the disclosure.

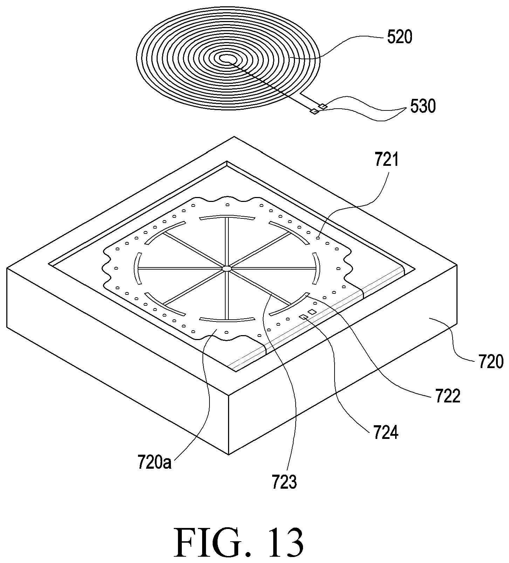

FIG. 13 is an enlarged view of area A of FIG. 12 according to various example embodiments of the disclosure.

According to various embodiments, the electronic device (e.g., the electronic device 101 of FIGS. 1 to 4) may include a rear plate (e.g., the rear plate 380 of FIG. 6) and a wireless charging structure 500. The wireless charging structure 500 may include an insert portion 510 and a wireless charging coil 520.

The wireless charging structure 500 of FIGS. 11 to 13 may be identical in whole or part to the structure of the wireless charging structure 500 of FIGS. 6 to 11.

Hereinafter, a manufacturing process for forming a wireless charging structure 500 and a manufacturing process for disposing the wireless charging structure 500 on a rear plate 380 are described.

According to various embodiments, a mold for forming the wireless charging structure 500 may be produced (process 10). For example, a separate mold may be produced to form a first insert portion (e.g., the wireless charging structure 500) which has a woven structure by molding the wireless charging coil 520 and terminals 530 along with an insert portion 510 which is a thermosetting material.

According to an embodiment, the mold 700 may include an upper mold portion 710 and a lower mold portion 720. Seating portions for disposing the wireless charging coil 520, terminals 530, and insert portion 510 may be included in the inside of each of the upper mold portion 710 and the lower mold portion 720. The upper mold portion 710 may include an injection opening 710a for introducing the pre-cure insert portion 510 (e.g., a thermosetting resin).

According to an embodiment, the mold may be subject to a design change to be able to produce a curved shape as well as a flat surface. The mold may be formed of various materials, such as metal, polymer, or wood, depending on the shape. According to an embodiment, the lower mold portion 720 may include a separate guide structure 720a for fixing or guiding the position of the wireless charging coil 520 corresponding to the planar direction and/or the height direction. The separate guide structure 720a may have a shape corresponding to the guide slot 513 (e.g., the guide slot 513 of FIGS. 7 and 8) formed in the insert portion 510. The guide slot 513 of the insert portion 510 and the guide structure 720a of the lower mold portion 720 (e.g., the receiving portion 721, the first guide slot 722, the second guide slot 723, the terminal placement area 724) may be formed in an engraved shape.

According to various embodiments, to place the wireless charging structure 500 in the recess of the rear plate (e.g., the rear plate 380 of FIG. 6), the wireless charging coil 520 may be produced first (process 20). The wireless charging coil 520 may be one layer wound in a first shape designated by a first number of turns. As another example, the wireless charging coil 520 may include a plurality of coils which may be produced in different numbers of turns and different shapes. The single coil may be provided in a form in which the inner center is open and, at the inner diameter end and/or the outer diameter end, conductive lines (e.g., terminals 530) electrically connectable to the circuit board 600 may be formed.

According to various embodiments, after the wireless charging coil 520 is fixed to the seating portion where the guide structure 720a in the mold (e.g., the upper mold portion 710 and the lower mold portion 720) is formed, the insert portion 510 formed of a thermosetting resin may be injected through the injection opening 710a of the upper mold portion 710 (process 30). The wireless charging coil 520 and the terminals 530 may be molded with the thermosetting resin insert portion 510 and form a woven structure, forming a first insert component (e.g., the wireless charging structure 500) (process 40).

Thereafter, the wireless charging structure 500 is inserted into a separate mold for injecting the rear plate 380 and, then, injection molding may be performed (process 50). Accordingly, the rear plate 380 and the wireless charging structure 500 coupled in the recess of the rear plate 380 may be produced.

Then, additional processing, such as painting, laser processing, or printing, may further be performed on the interior or exterior surface of the coupled structure of the rear plate 380 and the wireless charging structure 500 (process 60). After the processing, shield painting and/or CNC processing may further be performed (process 70).

According to an embodiment, the final cover structure may be produced in a flat or curved shape according to the injection molding method. The final cover structure may be divided by at least one boundary line due to different materials or different colors by the rear plate 380 and the wireless charging structure 500.

According to various embodiments, an electronic device (e.g., the electronic device 101 of FIGS. 1 to 4) may comprise a housing (e.g., 310 of FIGS. 2 and 3) forming at least a portion of an exterior of the electronic device, a wireless charging structure (e.g., 500 of FIG. 6) positioned in a recess of the housing, and a circuit board (e.g., 600 of FIG. 6) disposed in the housing and electrically connected with the wireless charging structure. The wireless charging structure may include a wireless charging coil (e.g., 520 of FIG. 6) and an insert portion (e.g., 510 of FIG. 6) formed to surround at least a portion of the wireless charging coil. The recess of the housing may include at least one protrusion (e.g., 381 of FIG. 8) for coupling with the insert portion, and the insert portion includes at least one receiving portion (e.g., 511 of FIG. 8) disposed along an edge of the wireless charging structure to couple with the at least one protrusion.

According to various embodiments, the insert portion may include a guide slot (e.g., 513 of FIG. 7) formed to align a position of the wireless charging coil and limit eccentricity.

According to various embodiments, the guide slot may include a first guide slot (e.g., 513a of FIG. 7) positioned to wholly or partially surround an outer line of the wireless charging coil and a second guide slot (e.g., 513b of FIG. 7) formed to allow the wireless charging coil to maintain a height from a surface of the insert portion.

According to various embodiments, the first guide slot may include a curved shape.

According to various embodiments, the first guide slot may correspond to a closed loop shape of the wireless charging coil and include a plurality of separated at least partially curved slots.

According to various embodiments, the second guide slot may extend from a portion of the first guide slot and is at least partially linear in shape.

According to various embodiments, the second guide slot may extend to a center of the wireless charging coil.

According to various embodiments, the housing may be formed of a first material, and the insert portion of the wireless charging structure may be formed of a second material different from the first material.

According to various embodiments, an injected material for the housing may include a thermoplastic material, and an injected material for the insert portion may include a thermosetting material.

According to various embodiments, the wireless charging coil may be molded along with the insert portion and then form a woven structure along with the insert portion hardened over time by heat to be coupled to form an integrated structure.

According to various embodiments, the wireless charging structure may further include terminals (e.g., 530 of FIG. 6) for electrical connection with the circuit board, as conductive lines extending from the wireless charging coil.

According to various embodiments, wherein, for coupling between the housing and the wireless charging structure, at least a portion of an edge of the recess of the housing may form an inversely tapered shape (e.g., 380b of FIG. 8).

According to various embodiments, the recess of the housing may be formed to have an increased surface area in contact with the insert portion to couple with the wireless charging structure.

According to various embodiments, the housing coupled with the wireless charging structure may comprise a rear plate (e.g., 380 of FIG. 6).

According to various embodiments, a first area of the wireless charging structure, in which the wireless charging coil is disposed, may be positioned on an inner surface of the rear plate, and a second area of the wireless charging structure, which extends from an edge of the first area, may be disposed up to a side surface of the rear plate.

According to various embodiments, an electronic device (e.g., the electronic device 101 of FIGS. 1 to 4) may comprise a housing (e.g., 310 of FIGS. 2 and 3) forming at least a portion of an exterior of the electronic device, a wireless charging structure (e.g., 500 of FIG. 6) at least partially positioned in a recess formed in an inner surface of the housing, and a circuit board (e.g., 600 of FIG. 6) disposed in the housing and electrically connected with the wireless charging structure. The wireless charging structure may a wireless charging coil (e.g., 520 of FIG. 6) and an insert portion (e.g., 510 of FIG. 6) formed to surround at least a portion of the wireless charging coil. The insert portion may include a guide slot (e.g., 513 of FIG. 7) formed to align a position of the wireless charging coil.

According to various embodiments, the recess area of the housing may include at least one protrusion for coupling with the insert portion, and the insert portion may include at least one receiving portion disposed along an edge of the wireless charging structure to couple with the at least one protrusion.

According to various embodiments, an injected material of the housing may include a thermoplastic material, and an injected material of the insert portion may include a thermosetting material.

According to various embodiments, the recess of the housing may form an inversely tapered shape at an edge thereof to couple the housing with the wireless charging structure.

According to various embodiments, the guide slot may include a first guide slot positioned to wholly or partially surround an outer line of the wireless charging coil and a second guide slot formed to allow the wireless charging coil to maintain a same height from a surface of the insert portion.

It is apparent to one of ordinary skill in the art that the cover member having the wireless charging structure disposed and the electronic device including the cover member according to various embodiments of the present invention as described above are not limited to the above-described embodiments and those shown in the drawings, and various changes, modifications, or alterations may be made thereto without departing from the scope of the present invention.

## Claims

1. An electronic device comprising:
a housing forming at least a portion of an exterior of the electronic device;
a wireless charging structure positioned in a recess of the housing; and
a circuit board disposed in the housing and electrically connected with the wireless charging structure,
wherein the wireless charging structure includes:
a wireless charging coil; and
an insert portion formed to surround at least a portion of the wireless charging coil, and
**characterized in that**
the recess of the housing includes at least one protrusion configured for coupling with the insert portion, and the insert portion includes at least one receiving portion disposed along an edge of the wireless charging structure configured to couple with the at least one protrusion.

2. The electronic device of claim 1, wherein the insert portion includes a guide slot configured to align a position of the wireless charging coil and limit eccentricity.

3. The electronic device of claim 2, wherein the guide slot includes:
a first guide slot positioned to wholly or partially surround an outer line of the wireless charging coil, and
a second guide slot configured to allow the wireless charging coil to maintain a height from a surface of the insert portion.

4. The electronic device of claim 3, wherein the first guide slot is at least partially curved.

5. The electronic device of claim 3, wherein the first guide slot corresponds to a closed loop shape of the wireless charging coil and includes a plurality of separated at least partially curved slots.

6. The electronic device of claim 3, wherein the second guide slot extends from a portion of the first guide slot and is at least partially linear in shape.

7. The electronic device of claim 6, wherein the second guide slot extends to a center of the wireless charging coil.

8. The electronic device of claim 1, wherein the housing is formed of a first material, and the insert portion of the wireless charging structure is formed of a second material different from the first material.

9. The electronic device of claim 1,
wherein an injected material for the housing includes a thermoplastic material, and
wherein an injected material for the insert portion includes a thermosetting material.

10. The electronic device of claim 9, wherein the wireless charging coil is molded along with the insert portion and forms a woven structure along with the insert portion hardened over time by heat to be coupled to form an integrated structure.

11. The electronic device of claim 1, wherein the wireless charging structure further includes terminals for electrical connection with the circuit board, as conductive lines extending from the wireless charging coil.

12. The electronic device of claim 1,
wherein, for coupling between the housing and the wireless charging structure, at least a portion of an edge of the recess of the housing forms an inversely tapered shape.

13. The electronic device of claim 1, wherein the recess of the housing is formed to have an increased surface area in contact with the insert portion to couple with the wireless charging structure.

14. The electronic device of claim 1, wherein the housing coupled with the wireless charging structure comprises a rear plate.

15. The electronic device of claim 14, wherein a first area of the wireless charging structure, in which the wireless charging coil is disposed, is positioned on an inner surface of the rear plate, and a second area of the wireless charging structure, which extends from an edge of the first area, is disposed up to a side surface of the rear plate.

## Patentansprüche

1. Elektronische Vorrichtung, umfassend:
ein Gehäuse, das mindestens einen Abschnitt einer Außenseite der elektronischen Vorrichtung bildet;
eine drahtlose Ladestruktur, die in einer Aussparung des Gehäuses positioniert ist; und
eine Leiterplatte, die in dem Gehäuse angeordnet ist und elektrisch mit der drahtlosen Ladestruktur verbunden ist,
wobei die drahtlose Ladestruktur Folgendes beinhaltet:
eine drahtlose Ladespule; und
einen Einsatzabschnitt, der gebildet ist, um mindestens einen Abschnitt der drahtlosen Ladespule zu umgeben, und **dadurch gekennzeichnet, dass** die Aussparung des Gehäuses mindestens einen Vorsprung beinhaltet, der zum Koppeln mit dem Einsatzabschnitt konfiguriert ist, und der Einsatzabschnitt mindestens einen Aufnahmeabschnitt beinhaltet, der entlang einer Kante der drahtlosen Ladestruktur angeordnet ist, die dazu konfiguriert ist, mit dem mindestens einen Vorsprung gekoppelt zu werden.

2. Elektronische Vorrichtung nach Anspruch 1, wobei der Einsatzabschnitt einen Führungsschlitz beinhaltet, der dazu konfiguriert ist, eine Position der drahtlosen Ladespule auszurichten und eine Exzentrizität zu begrenzen.

3. Elektronische Vorrichtung nach Anspruch 2, wobei der Führungsschlitz Folgendes beinhaltet:
einen ersten Führungsschlitz, der dazu positioniert ist, eine Außenleitung der drahtlosen Ladespule ganz oder teilweise zu umgeben, und
einen zweiten Führungsschlitz, der dazu konfiguriert ist, zu ermöglichen, dass die drahtlose Ladespule eine Höhe von einer Oberfläche des Einsatzabschnitts aufrechterhält.

4. Elektronische Vorrichtung nach Anspruch 3, wobei der erste Führungsschlitz mindestens teilweise gekrümmt ist.

5. Elektronische Vorrichtung nach Anspruch 3, wobei der erste Führungsschlitz einer geschlossenen Schleifenform der drahtlosen Ladespule entspricht und eine Vielzahl von getrennten, mindestens teilweise gekrümmten Schlitzen beinhaltet.

6. Elektronische Vorrichtung nach Anspruch 3, wobei sich der zweite Führungsschlitz von einem Abschnitt des ersten Führungsschlitzes erstreckt und mindestens teilweise linear geformt ist.

7. Elektronische Vorrichtung nach Anspruch 6, wobei sich der zweite Führungsschlitz zu einer Mitte der drahtlosen Ladespule erstreckt.

8. Elektronische Vorrichtung nach Anspruch 1, wobei das Gehäuse aus einem ersten Material gebildet ist und der Einsatzabschnitt der drahtlosen Ladestruktur aus einem zweiten Material gebildet ist, das sich von dem ersten Material unterscheidet.

9. Elektronische Vorrichtung nach Anspruch 1, wobei ein eingespritztes Material für das Gehäuse ein thermoplastisches Material beinhaltet und wobei ein eingespritztes Material für den Einsatzabschnitt ein wärmehärtendes Material beinhaltet.

10. Elektronische Vorrichtung nach Anspruch 9, wobei die drahtlose Ladespule zusammen mit dem Einsatzabschnitt geformt ist und eine gewebte Struktur zusammen mit dem Einsatzabschnitt bildet, der im Laufe der Zeit durch Wärme gehärtet wird, um gekoppelt zu sein, um eine integrierte Struktur zu bilden.

11. Elektronische Vorrichtung nach Anspruch 1, wobei die drahtlose Ladestruktur ferner Anschlüsse für eine elektrische Verbindung mit der Leiterplatte als leitende Leitungen, die sich von der drahtlosen Ladespule erstrecken, beinhaltet.

12. Elektronische Vorrichtung nach Anspruch 1,
wobei zum Koppeln zwischen dem Gehäuse und der drahtlosen Ladestruktur mindestens ein Abschnitt einer Kante der Aussparung des Gehäuses eine sich umgekehrt verjüngende Form bildet.

13. Elektronische Vorrichtung nach Anspruch 1, wobei die Aussparung des Gehäuses gebildet ist, um einen vergrößerte Oberflächenbereich in Kontakt mit dem Einsatzabschnitt aufzuweisen, um mit der drahtlosen Ladestruktur gekoppelt zu sein.

14. Elektronische Vorrichtung nach Anspruch 1, wobei das Gehäuse, das mit der drahtlosen Ladestruktur gekoppelt ist, eine hintere Platte umfasst.

15. Elektronische Vorrichtung nach Anspruch 14, wobei ein erster Bereich der drahtlosen Ladestruktur, in dem die drahtlose Ladespule angeordnet ist, an einer inneren Oberfläche der hinteren Platte positioniert ist und ein zweiter Bereich der drahtlosen Ladestruktur, der sich von einer Kante des ersten Bereichs erstreckt, bis zu einer seitlichen Oberfläche der hinteren Platte angeordnet ist.

## Revendications

1. Dispositif électronique comprenant :
un boîtier formant au moins une partie d'un extérieur du dispositif électronique ;
une structure de charge sans fil positionnée dans un renfoncement du boîtier ; et
une carte de circuit disposée dans le boîtier et connectée électriquement à la structure de charge sans fil,
ladite structure de charge sans fil comprenant :
une bobine de charge sans fil ; et
une partie d'insert formée pour entourer au moins une partie de la bobine de charge sans fil, et **caractérisé en ce que** le renfoncement du boîtier comprend au moins une saillie conçue pour se coupler à la partie d'insert, et ladite partie d'insert comprenant au moins une partie de réception disposée le long d'un bord de la structure de charge sans fil conçue pour se coupler à ladite au moins une saillie.

2. Dispositif électronique de la revendication 1, ladite partie d'insert comprenant une fente de guidage conçue pour aligner une position de la bobine de charge sans fil et limiter l'excentricité.

3. Dispositif électronique de la revendication 2, ladite fente de guidage comprenant :
une première fente de guidage positionnée pour entourer entièrement ou partiellement une ligne externe de la bobine de charge sans fil, et
une seconde fente de guidage conçue pour permettre à la bobine de charge sans fil de maintenir une hauteur à partir d'une surface de la partie d'insert.

4. Dispositif électronique de la revendication 3, ladite première fente de guidage étant au moins partiellement incurvée.

5. Dispositif électronique de la revendication 3, ladite première fente de guidage correspondant à une forme de boucle fermée de la bobine de charge sans fil et comprenant une pluralité de fentes séparées au moins partiellement incurvées.

6. Dispositif électronique de la revendication 3, ladite seconde fente de guidage s'étendant à partir d'une partie de la première fente de guidage et possédant une forme au moins partiellement linéaire.

7. Dispositif électronique de la revendication 6, ladite seconde fente de guidage s'étendant vers un centre de la bobine de charge sans fil.

8. Dispositif électronique de la revendication 1, ledit boîtier étant formé d'un premier matériau, et ladite partie d'insert de la structure de charge sans fil étant formée d'un second matériau différent du premier matériau.

9. Dispositif électronique de la revendication 1,
un matériau injecté pour le boîtier comprenant un matériau thermoplastique, et un matériau injecté pour la partie d'insert comprenant un matériau thermodurcissable.

10. Dispositif électronique de la revendication 9, ladite bobine de charge sans fil étant moulée avec la partie d'insert et formant une structure tissée avec la partie d'insert durcie dans le temps par la chaleur pour être couplées afin de former une structure intégrée.

11. Dispositif électronique de la revendication 1, ladite structure de charge sans fil comprenant en outre des bornes pour une connexion électrique avec la carte de circuit, sous forme de lignes conductrices s'étendant à partir de la bobine de charge sans fil.

12. Dispositif électronique de la revendication 1,
pour le couplage entre le boîtier et la structure de charge sans fil, au moins une partie d'un bord du renfoncement du boîtier formant une forme conique inversée.

13. Dispositif électronique de la revendication 1, ledit renfoncement du boîtier étant formé pour posséder une aire accrue en contact avec la partie d'insert pour se coupler à la structure de charge sans fil.

14. Dispositif électronique de la revendication 1, ledit boîtier couplé à ladite structure de charge sans fil comprenant une plaque arrière.

15. Dispositif électronique de la revendication 14, une première zone de la structure de charge sans fil, dans laquelle la bobine de charge sans fil est disposée, étant positionnée sur une surface interne de la plaque arrière, et une seconde zone de la structure de charge sans fil, qui s'étend à partir d'un bord de la première zone, étant disposée jusqu'à une surface latérale de la plaque arrière.
